# EUROPEAN PATENT APPLICATION

(11) **EP 3 185 021 A1**
(43) Date of publication of application: **28.06.2017**
(21) Application number: 15461587.6
(22) Date of filing: 23.12.2015
(51) Int. Cl.: G01R 22/10, G01D 4/00

(54) **MULTIPHASE ELECTRICITY METER BASED ON A CONFIGURABLE PROCESSOR AND A REAL-TIME SYSTEM, HEREINAFTER REFERRED TO AS DIGITAL ELECTRICITY MEASUREMENT SYSTEM, FOR USE IN SMART GRID POWER NETWORKS**

(71) Applicant: Phoenix Systems Sp. z o.o., 04-163 Warszawa (PL)
(72) Inventor: Pisarczyk, Pawel, 04-683 Warszawa (PL)
(74) Representative: Sielewiesiuk, Jakub

(57) **Abstract**

The object of the invention is a multiphase electricity meter based on a configurable microprocessor and on a real-time system, hereinafter referred to as Digital Electricity Measurement System, for use in Smart Grid power networks, characterised in that it comprises a single configurable microprocessor (1) to perform functions of measurement and communication, and the microprocessor (1) is connected via a digital interface IF (3,4,5,13) to analog front-end circuits, AFE, for receiving measurement signals AFE_{M} (8), for receiving and transmitting information signals by means of a power line AFE_{PLC} (7) and/or for generating and receiving a radio signal AFE_{Radio} (6).

## Description

The object of the invention is a multiphase electricity meter for Smart Grid networks, built based on a single configurable microprocessor (e.g. Cadence's Xtensa) and on a real-time operating system.

The US patent application US20120041696 describes architecture of an electricity meter with an extended functionality, which allows for various applications to be implemented on the electricity meter. The above mentioned invention consists of a main processor, which can be a Digital Signal Processor (DSP), a general-purpose processor or a gate array. A number of peripheral devices are connected to the main processor directly or by means of another DSP (so called preprocessor). The basic devices used to perform measurement functions are a current sensor connected to sigma-delta converters (20 KS/s, 24 bit) and sigma-delta converters (20 KS/s, 24 bit) connected directly to the power line. Another device is a PLC signal emitter based on DSP, used for the communication signal input to the power line. Other devices connected to the processor via an optional preprocessor are: a detector of power interruptions, a power controlling unit, a high-precision clock, an Analog Front End circuit for radio communication within the band of 400-1.2 GHz, a digital radio for communication within the band of 1.8-2.8 GHz through PS&FSK modulation, an optical port, a magnetic field detector, a contactor, a tamper and an LCD display. The main processor runs under the control of the kernel of an open-source general-purpose operating system (Linux kernel), on the basis of which an environment for application development is implemented. The preprocessor is intended to perform complex algorithms, e.g. for determining energy parameters, for processing the PLC signal in order to reduce the load of the main processor. The object of the claims is an electricity meter having an architecture as described above, consisting of at least one sensor of the measurement signal, allowing to specify energy consumption profile of the customer, and a data processor that processes this signal. Another claim relates to the processing of the measurement signal in order to determine the type of devices that consume energy. A database in which the data processor stores load profiles together with types of said load is also claimed. Architecture of the measurement system as described in the above mentioned application is based on a number of processors - a main processor, an optional DSP preprocessor for data processing, a DSP embedded in the PLC signal emitter, and does not allow for the software implementation of PLC due to the parameters of analog-to-digital converters receiving voltage signals from the line, which are insufficient for such communication. Despite the postulated universality, this is a traditional architecture, consisting of many (at least two) processors.

In turn, the Patent Application US20140167977 describes an architecture of Smart Grid node, which is based on a universal microprocessor system (SOM) consisting of a processor equipped with a memory management unit (MMU), a RAM memory (64 MB) and a Flash memory (128 MB), a PIC microcontroller equipped with a real time clock (RTC), an EPF module for controlling power and an additional PMIC controller for power control. The SOM module is equipped with the following interfaces: 2xUSB, 1xSPI, 1xSDIO, 5xUART, 3 analog-to-digital converters, 2xI2C, GPIO. The SOM module has an 80-pin edge connector, which is used to connect to Smart Grid devices such as an electricity meter, a disconnector, etc. In case of the energy meter implementation, a system specifying energy parameters is connected to the SOM module via UART or GPIO interface. A PLC modem or a radio modem may also be connected by means of the interfaces and the edge connector. The SOM module runs under the control of Linux operating system or any other modern operating system. The object of the claims is an SOM module and its use for the construction of Smart Grid devices.

The aim of the invention is to develop a universal hardware construction of an electricity meter, allowing for support of popular Smart Grid standards for communication via power lines (such as S-FSK, PRIME, G3, IEEE P1901.2) and for radio communication (such as IEEE 802.15.4, IEEE 802.15.4g) only through the use of appropriate software running on a single processor which, in addition to communication functions, also performs other tasks, including functions for measuring electricity parameters. Communication via power lines will be interchangeably referred to as PLC (Power Line Communication).

The present invention is intended to keep very low production costs for the measurement system while maintaining high universality and the ability to run different applications.

The object of the present invention is a multiphase electricity meter based on a configurable microprocessor and on a real-time system, hereinafter referred to as Digital Electricity Measurement System, for use in Smart Grid power networks, characterised in that it comprises a single configurable microprocessor to perform functions of measurement and communication, and the microprocessor is connected via a digital interface IF to AFE circuits for obtaining receiving measurement signals AFE_{M}, for receiving and transmitting information signals by means of a power line AFE_{PLC} and/or for generating and receiving a radio signal AFE_{Radio}.

Preferably, the meter according to the invention has a subsystem implementing measurement functions and a subsystem implementing communication functions, and despite these subsystems having shared computing and storage resources, they are separated from each other using hardware protection mechanisms embedded in programming model of the configurable microprocessor and by means of appropriate mechanisms of the real time operating system, which ensure an appropriate rigour of time for the implementation of programs, especially with regard to guaranteeing operational reliability of the subsystem implementing measurement functions, according to legal requirements to which electricity meters operating in Smart Grid networks are subject.

Preferably, the entire functionality of the meter according to the invention, allowing support of popular Smart Grid standards for communication via power lines, especially such as S-FSK, PRIME, G3, IEEEP1901.2 and for radio communication, especially such as IEEE 802.15.4, IEEE 802.15.4g, is realised only through the use of appropriate software running on a single configurable microprocessor which, in addition to measurement and communication functions, also performs other tasks, including functions for measuring quality parameters of electricity.

In a preferable embodiment, the configurable microprocessor is connected via a digital interface IF to an analog front-end circuit, AFE_{PLC}, used to receive and transmit information signals by means of a power line with the use of a narrowband modulation, especially S-FSK, BPSK, OFDM, comprising an analog-to-digital converter for receiving a communication signal and a digital-to-analog converter, used to generate such signal, and the analog front-end circuit, AFE, is coupled to any number of available phases, wherein optional front-end circuit AFE_{PLC} for communication via a power line can be simplified and contain only some of converters.

Then it is preferred that the configurable microprocessor has an embedded digital interface IF by means of which it is connected to the analog front-end circuit, AFE_{Radio}, used to generate and to receive a radio signal carrying information with the use of any digital modulation, especially S-FSK, BPSK, OFDM, CDMA.

In a particularly preferred embodiment, the analog front-end circuit, AFE_{M}, for receiving measurement signals is integrated with the analog front-end circuit, AFE_{PLC}, for PLC communication by means of power lines.

Alternatively it is preferred that the meter according to the invention does not have any analog front-end circuit, AFE_{Radio} (6), for radio communication.

Preferably, the analog front-end circuit, AFE_{M} (8), for receiving measurement signals is integrated with the analog front-end circuit, AFE_{PLC}, for PLC communication by means of power lines.

Preferably, the analog front-end circuit, AFE, for communication by means of a power line does not contain any converter, and digital-to-analog and analog-to-digital converters embedded in the configurable microprocessor are configured to transmit and receive signals by means of a power line.

Preferably, the analog front-end circuit, AFE, for communication by means of a power line is equipped only with a digital-to-analog converter, and an analog-to-digital converter embedded in the configurable microprocessor is configured to receive an information signal by means of a power line.

The solution according to the present invention uses a single configurable microprocessor to implement measurement and communication functions. Separation between subsystems implementing the said functions by means of shared computing and storage resources is done with the use of hardware protection mechanisms, embedded in programming model of the processor and by means of appropriate mechanisms of the real time operating system which ensure an appropriate rigour of time for the implementation of programs. In particular, this relates to guaranteeing operational reliability of the subsystem implementing measurement functions, according to legal requirements to which electricity meters operating in Smart Grid networks are subject.

The universality of applications of the counter according to the inventions is achieved by the SOM module which is a general-purpose microprocessor system equipped with many interfaces used for connecting peripheral devices, e.g. a PLC modem or a modem for radio communication. Operational tests of the energy meter for SmartGrid networks according to the invention showed that it allows obtaining the same or lower costs of hardware components used for its production because several dedicated microprocessor circuits, used to implement measurement, communication and control functions, are replaced by a single microprocessor circuit with an appropriate computing power and its cost is close to the total cost of all the circuits. The highest savings are achieved at the level of production costs of the measurement system. Single type of hardware construction, produced within a single technological process, is able to support different types of communication used in Smart Grid networks and to implement various measurement algorithms, including algorithms relating to measurement of power quality. With the use of the configurable processor, it is possible to obtain minimal power consumption while maintaining high universality of the solution.

### Preferred Embodiment of the Invention

The invention is illustrated in exemplary constructional solutions in which:
Fig. 1 shows a basic diagram of the meter according to the invention;
Fig. 2 shows an example of a constructional solution of the meter with an analog front-end circuit for PLC communication, integrated with an analog front-end circuit for receiving measurement signals and a separated analog front-end circuit for radio communication,
Fig. 3 shows an example of a constructional solution of the meter with an analog front-end circuit for PLC, an analog front-end circuit for receiving measurement signals without any analog front-end circuit for radio communication,
Fig. 4 shows an example of a constructional solution of the meter with an analog front-end circuit for PLC, integrated with an analog front-end circuit for receiving measurement signals without any analog front-end circuit for radio communication,
Fig. 5 shows an example of a constructional solution of the meter in which an analog front-end circuit for PLC is devoid of analog-to-digital and digital-to-analog converters and is connected to the processor through embedded in the processor an analog-to-digital converter, for receiving signals, and through a digital-to-analog converter for emitting communication signals, and
Fig. 6 shows an example of a constructional solution in which an analog front-end circuit for PLC is devoid of analog-to-digital converter and is connected to the processor through an analog-to-digital converter for receiving communication signals and through a digital interface for transmitting communication signals.

In the drawing, the following designations were used:
1 - Configurable microprocessor; 2 - Computing cores = CPU; 3 - Digital interface for connecting analog front-end circuit for radio communication = IF_{Radio}; 4 - Digital interface for connecting analog front-end circuit for PLC= IF_{PLC}; 5 - Digital interface for connecting analog front-end circuit for receiving measurement signals = IF_{M}; 6 - Analog front-end circuit for radio communication = AFE_{Radio}; 7 - Analog front-end circuit for PLC communication = AFE_{PLC}; 8 - Analog front-end circuit for receiving measurement signals = AFE_{M}; 9 - Analog-to-digital converter for connecting a simplified analog front-end circuit for receiving measurement signals; 10 - Digital-to-analog converter for connecting a simplified analog front-end circuit for receiving measurement signals; 11 - Phase conductors of the power line; 12 - Neutral conductor of the power line; 13 - Digital interface for connecting analog front-end circuit for PLC, integrated with an analog front-end circuit for receiving measurement signals= IF_{M} + IF_{PLC} ; 14 - Analog front-end circuit constituting an integrated analog front-end circuit for PLC communication and an analog front-end circuit for receiving measurement signals = AFE_{M} + AFE_{PLC}; 15 - Simplified analog front-end circuit for PLC communication without analog-to-digital and digital-to-analog converters= AFE_{PLC w/o DAC w/o ADC}; 16 - Simplified analog front-end circuit for PLC without analog-to-digital converter= AFE_{PLC w/o ADC}; 17 - Power line.

In a preferred embodiment, a configurable microprocessor 1 is connected via a digital interface 3, 4 or 5 to an analog front-end circuit = AFE_{M} 8 for receiving measurement signals, comprising sigma-delta analog-to-digital converters 9, one pair for each phase, used for converting analog measurement signals of current and voltage and sigma-delta analog-to-digital converter 9 used for measuring current in a neutral wire 12.

The configurable microprocessor 1 is connected via a digital interface to an analog front-end circuit AFE_{PLC} 7, used for receiving and transmitting information signals by means of a power line 17 with the use of a narrowband modulation (e.g. S-FSK, BPSK or OFDM), comprising an analog-to-digital converter 9 for receiving a communication signal and a digital-to-analog converter 10 used to generate such signal. The AFE circuit is coupled to any number of available phases. The AFE circuit for communication via the power line 17 may also be simplified and may not comprise the complete set of converters. It is possible to have a variant in which the AFE circuit for communication by means of the power line 17 is equipped with only the digital-to-analog converter 10, and the information signal is received by means of the analog-to-digital converter 9 embedded in the microprocessor 1 and a variant in which the analog front-end circuit AFE_{PLC} 7 for communication by means of the power line 17 does not comprise any of the converters, and the signal is transmitted and received by means of the digital-to-analog converter 10 and the analog-to-digital converter 9 embedded in the microprocessor 1. The configurable microprocessor 1 has an embedded digital interface by means of which it is connected to the analog front-end circuit, AFE_{Radio} 6, used to generate and to receive a radio signal, in unlicensed frequency bands, carrying information with the use of any digital modulation (e.g. S-FSK, BPSK, OFDM, CDMA).

The configurable microprocessor 1 is to be understood as a processor with an expandable and configurable instruction set (programming model adapted to application) e.g. Cadence's Xtensa or EnSilica's eSi-RISC. In the described invention, the processor, by means of an expanded instruction set, may implement procedures of convolutional, repetition, redundant coding and N-point fast Fourier transformation (FFT). The said procedures may be used both for the needs of communication via power lines 17, radio communication and for the needs of implementation of measurements of energy parameters. Implementation of computationally intensive algorithms by means of dedicated instructions of the configurable processor allows a significant (by several times) reduction of power consumption compared to a standard processor.

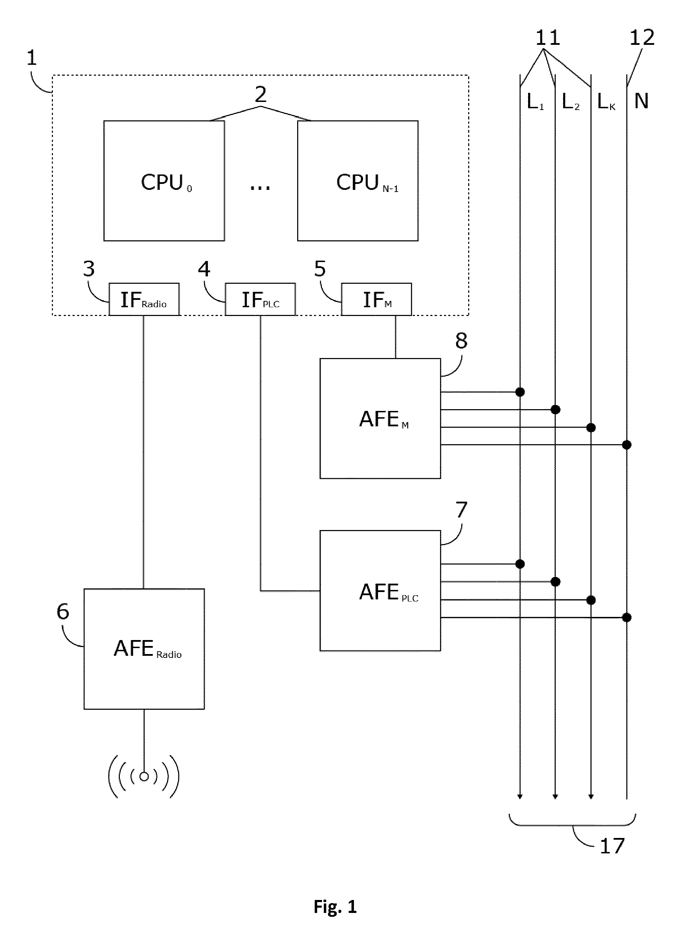

The energy meter, shown in Fig. 1, for Smart Grid networks is equipped with a configurable microprocessor 1 comprising one or more computing cores (CPU) 2, connected via a digital interface IF_{Radio} 3 to an analog front-end circuit for radio communication 6, connected via a digital interface IF_{PLC} 4 to an analog front-end circuit for communication AFE_{PLC} 7, connected via a digital interface IF_{M} 5 to an analog front-end circuit AFE_{M} 8, for receiving measurement signals. The analog front-end circuit AFE_{PLC} 7 for PLC communication is connected to one or more phase conductors 11 of the power line 17 and to a neutral conductor 12 of the power line 17. The analog front-end circuit AFE_{PLC} 7 for PLC communication is responsible for coupling to the power line 17 and for receiving and emitting information signals carried via conductors of the power line 17. The analog front-end circuit AFE_{M} 8 for receiving measurement signals is responsible for receiving measurement signals of voltage between each phase and the neutral conductor 12 and signals of current flowing through the phase conductors 11 of the power line 17 and the neutral conductor 12 of the power line 17. The analog front-end circuit AFE_{Radio} 6 for radio communication is responsible for receiving and emitting radio signals in a specific frequency band. Radio signals received by the analog front-end circuit AFE_{Radio} 6 for radio communication are transmitted to the configurable microprocessor 1 via a digital interface IF_{Radio} 3, and are emitted based on a digital signal transmitted by the microprocessor 1 by means of the same digital interface IF_{Radio} 3.

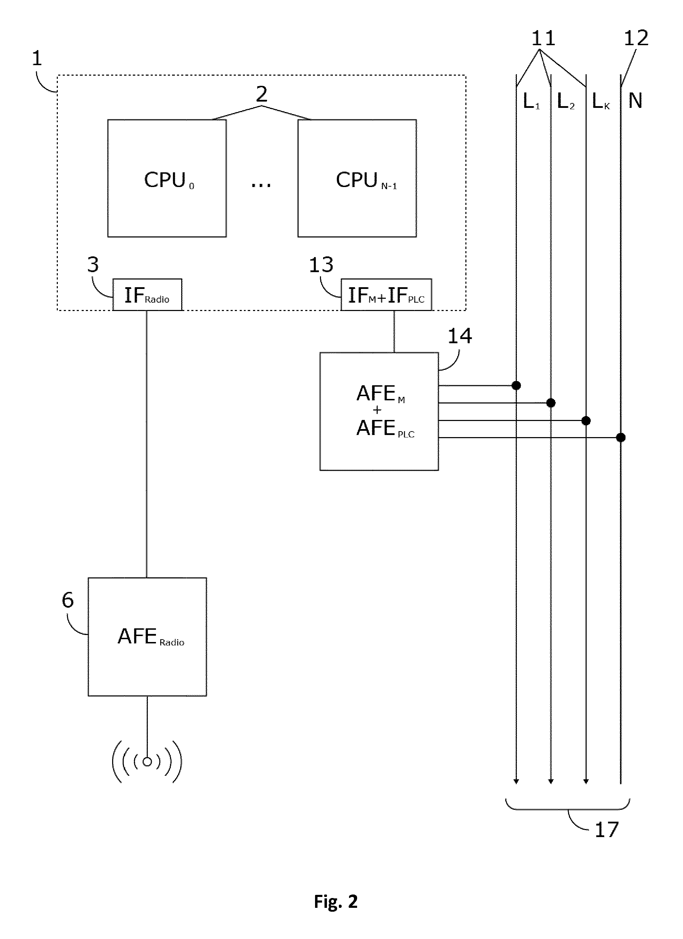

The meter according to the invention, as shown in Fig. 2, in another exemplary constructional solution differs from the meter of Fig. 1 in that the analog front-end circuits AFE_{PLC} 7 and AFE_{M} 8 are integrated with each other in the form of a single analog front-end circuit AFE_{M} + AFE_{PLC} 14, and digital signals of voltage between each phase and the neutral conductor 12 which are a convolution of the measurement signal and the communication signal are transmitted to the microprocessor 1, and digital signals which are to be generated from the power line 17 are transmitted by means of the interface IF_{M} + IF_{PLC} 13 to the analog front-end circuit AFE_{M} + AFE_{PLC} 14. The analog front-end circuit for radio communication AFE_{Radio} 6 is connected to the microprocessor 1 by means of the digital interface IF_{Radio} 3.

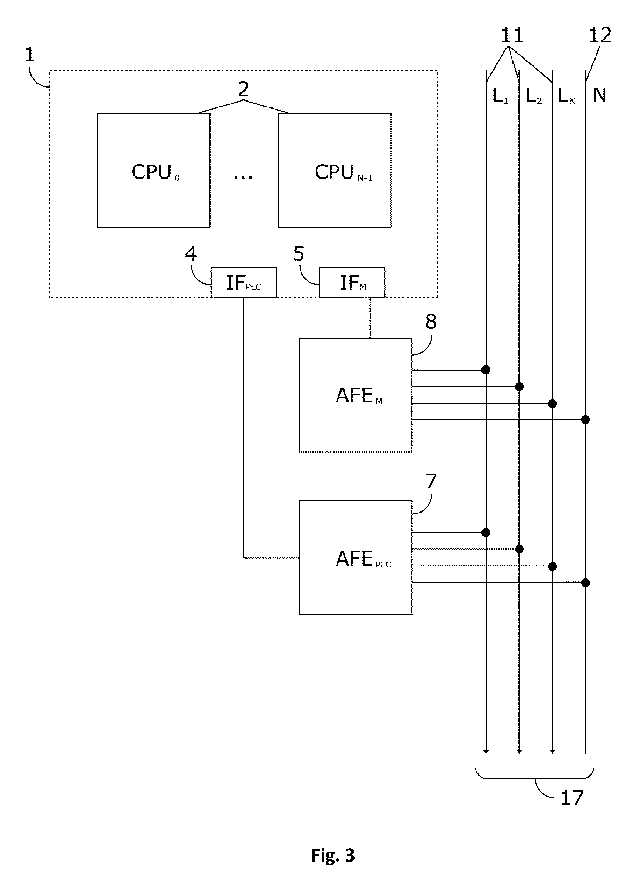

The meter according to the invention, as shown in Fig. 3, in another exemplary constructional solution differs from the meter of Fig. 1 in that the construction is devoid of the analog front-end circuit AFE_{Radio} 6 for radio communication.

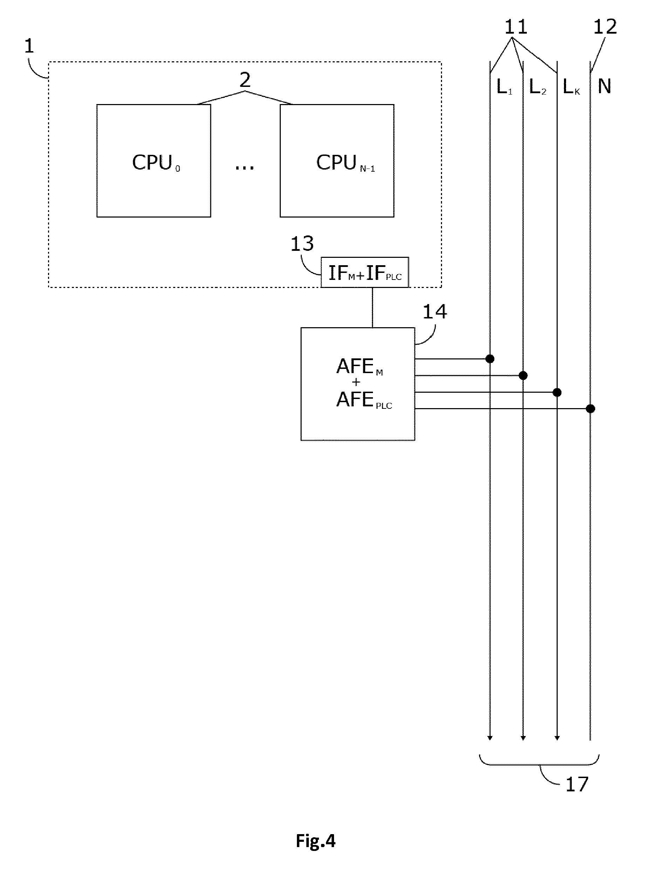

The meter according to the invention, as shown in Fig. 4, in another exemplary constructional solution differs from the meter of Fig. 2 in that the construction is devoid of the analog front-end circuit AFE_{Radio} 6 for radio communication.

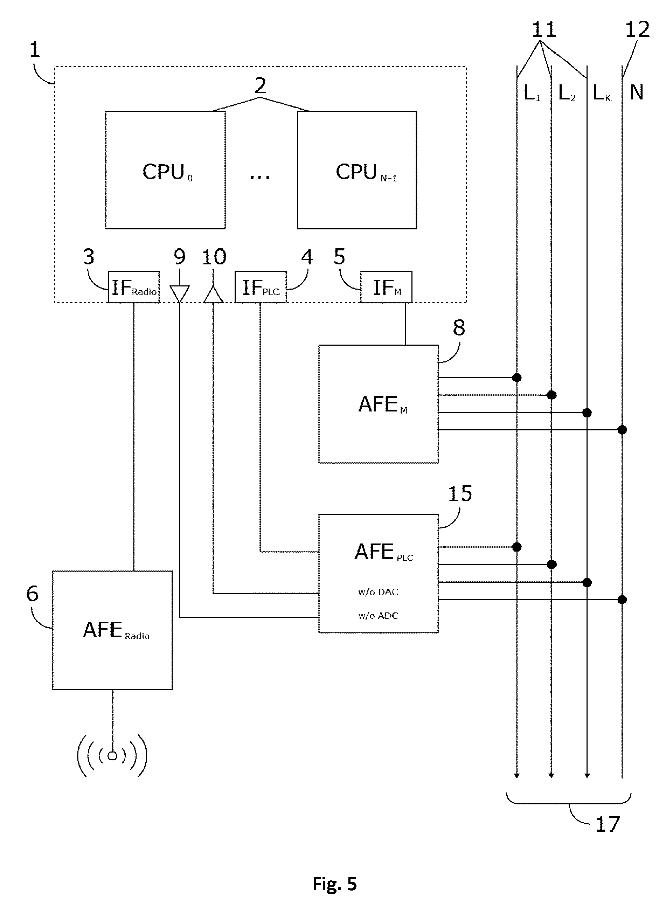

The meter according to the invention, as shown in Fig. 5, in another exemplary constructional solution differs from the meter of Fig. 1, Fig. 2, Fig. 3 and Fig. 4 in that the analog front-end circuit AFE for PLC communication is simplified and devoid of the analog-to-digital converter 9 and the digital-to-analog converter 10. Simplified analog front-end circuit AFE for PLC without analog-to-digital and digital-to-analog converters is connected to the microprocessor 1 by means of the analog-to-digital converter 9 and the digital-to-analog converter 10 both embedded in the microprocessor 1 and by means of the digital interface IF_{PLC} 4.

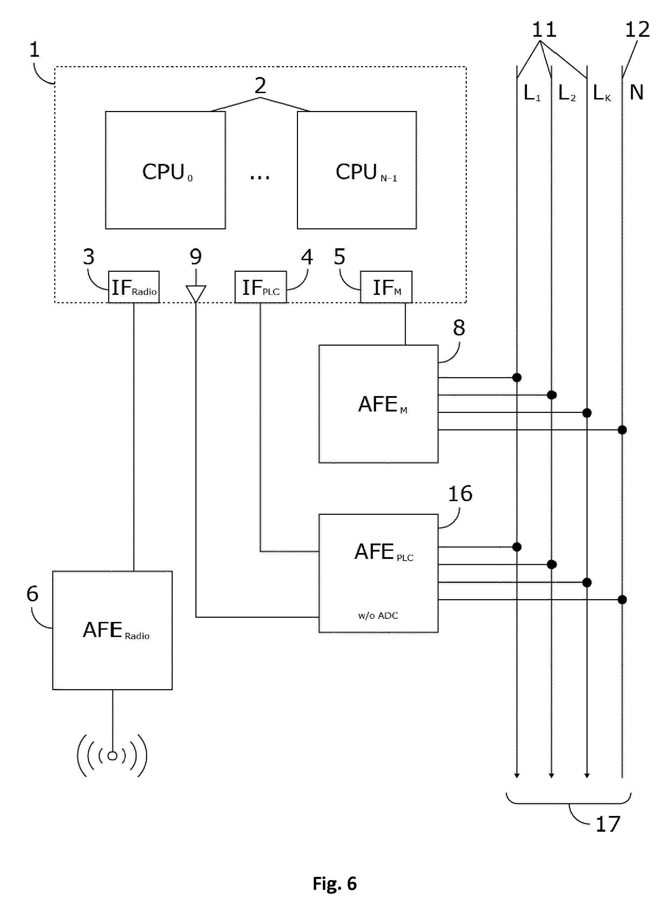

The meter according to the invention, as shown in Fig. 6, in another exemplary constructional solution differs from the meter of Fig. 5 in that the analog front-end circuit AFE for PLC communication is devoid of the analog-to-digital converter. Simplified analog front-end circuit for PLC without the analog-to-digital converter 16 is connected to the microprocessor 1 by means of the analog-to-digital converter 9 embedded in the microprocessor 1 and by means of the digital interface IF_{PLC} 4.

The solution suggested in the present application uses only a single configurable microprocessor 1 connected by means of digital interfaces IF to the analog front-end circuits AFE for PLC, for receiving measurement signals and for radio communication. In addition, it should be emphasized that the essence of sharing a single processor by many different functions is the use of a real-time operating system, which separates software modules and provides them with appropriate computing resources, at the appropriate time.

In order to facilitate the implementation of various devices, the microprocessor system runs under a general-purpose operating system allowing creation of different applications. It is not possible to modify the functionality of the device, e.g. the scope of the measured energy parameters by changing the software. In the patent application, universal applicability is ensured exclusively by the software and the single processor. All functions of the device (e.g. measurement, communication) are implemented only by appropriate software operating under a real-time operating system.

## Claims

1. A multiphase electricity meter based on a configurable microprocessor and on a real-time system, hereinafter referred to as Digital Electricity Measurement System, for use in Smart Grid power networks, **characterised in that** it comprises a single configurable microprocessor (1) to perform functions of measurement and communication, and the microprocessor (1) is connected via a digital interface IF (3,4,5,13) to analog front-end circuits, AFE, for receiving measurement signals AFE_{M} (8), for receiving and transmitting information signals by means of a power line AFE_{PLC} (7) and/or for generating and receiving a radio signal AFE_{Radio} (6).

2. The meter according to claim 1, **characterised in that** it has a subsystem implementing measurement functions and a subsystem implementing communication functions, and despite these subsystems having shared computing and storage resources, they are separated from each other using hardware protection mechanisms embedded in programming model of the configurable microprocessor (1) and by means of appropriate mechanisms of the real time operating system which ensure an appropriate rigour of time for the execution of programs, especially with regard to guaranteeing operational reliability of the subsystem executing measurement functions, according to legal requirements to which electricity meters operating in Smart Grid networks are subject.

3. The meter according to claim 1 or 2, **characterised in that** its entire functionality allowing support of popular Smart Grid standards for communication via power lines, especially such as S-FSK, PRIME, G3, IEEEP1901.2 and for radio communication, especially such as IEEE 802.15.4, IEEE 802.15.4g, is implemented only through the use of appropriate software running on the single configurable microprocessor (1) which, in addition to measurement and communication functions, also performs other tasks, including functions for measuring quality parameters of electricity.

4. The meter according to claim 1, 2 or 3, **characterised in that** the configurable microprocessor (1) is connected via a digital interface IF (3,4,5,13) to analog front-end circuit, AFE_{PLC} (7), used to receive and transmit information signals by means of a power line with the use of a narrowband modulation, especially S-FSK, BPSK, OFDM, comprising an analog-to-digital converter (9) for receiving a communication signal and a digital-to-analog converter (10), used to generate such signal, and the analog front-end circuit, AFE, is coupled to any number of available phases, wherein optionally the AFE_{PLC} circuit for communication via a power line can be simplified and contain only some converters.

5. The meter according to claim 4, **characterised in that** the configurable microprocessor (1) has an embedded digital interface IF (3,4,5,13) by means of which it is connected to the analog front-end circuit, AFE_{Radio} (6), used to generate and to receive a radio signal carrying information with the use of any digital modulation, especially S-FSK, BPSK, OFDM, CDMA.

6. The meter according to claim 5, **characterised in that** the analog front-end circuit, AFE_{M} (8), for receiving measurement signals is integrated with the analog front-end circuit, AFE_{PLC} (4), for communication by means of power lines - Power Line Communication, PLC.

7. The meter according to claim 5, **characterised in that** it does not have any analog front-end circuit, AFE_{Radio} (6), for radio communication.

8. The meter according to claim 4, **characterised in that** the analog front-end circuit, AFE_{M} (8), for receiving measurement signals is integrated with the analog front-end circuit, AFE_{PLC} (7), for communication by means of power lines - Power Line Communication, PLC.

9. The meter according to claim 5, **characterised in that** the analog front-end circuit, AFE, for communication by means of a power line does not contain any converter, and digital-to-analog converters (10) and analog-to-digital converters (9) embedded in the configurable microprocessor (1) are configured to transmit and receive signals by means of a power line (17).

10. The meter according to claim 5, **characterised in that** the analog front-end circuit, AFE, for communication by means of a power line is equipped only with a digital-to-analog converter (10), and an analog-to-digital converter (9) embedded in the configurable microprocessor (1) is configured to receive an information signal by means of a power line (17).
